# EUROPEAN PATENT APPLICATION

(11) **EP 4 477 786 A1**
(43) Date of publication of application: **18.12.2024**
(21) Application number: 23922174.0
(22) Date of filing: 24.04.2023
(51) Int. Cl.: C30B 9/06, C30B 29/36

(54) **METHOD FOR PREPARING 3C-SIC SINGLE CRYSTAL**

(30) Priority: 14.02.2023 CN 202310109001
(71) Applicant: Institute of Physics, Chinese Academy of Sciences, Beijing 100190 (CN)
(72) Inventor: CHEN, Xiaolong, Beijing 100190 (CN); LI, Hui, Beijing 100190 (CN); WANG, Guobin, Beijing 100190 (CN); SHENG, Da, Beijing 100190 (CN); WANG, Wenjun, Beijing 100190 (CN); GUO, Jiangang, Beijing 100190 (CN)
(74) Representative: The IP Asset Partnership Limited
(86) International application number: PCT/CN2023/090284
(87) International publication number: WO 2024/169045

(57) **Abstract**

The present invention provides a method for preparing 3C-SiC single crystals, comprising the steps of: (1) fixing a SiC seed crystal to a graphite seed crystal holder, and then fixing the graphite seed crystal holder to a graphite lifting rod; (2) placing a flux containing Si and Al in a graphite crucible; (3) then loading the graphite crucible and the graphite lifting rod into a growth furnace; (4) vacuumizing the growth furnace, and then introducing a gas to control the gas pressure in the growth furnace and the crystal form of 3C-SiC; (5) heating the graphite crucible until the flux is completely molten to form a melt, and reaches the growth temperature of SiC; (6) pushing down the graphite lifting rod to make the SiC seed crystals contact with the melt, thereby growing 3C-SiC single crystals; wherein the flux further contains a 3d-transition metal with a melting point lower than the growth temperature of SiC. The method of the present invention can achieve the growth of high-quality, large-size (such as 2-6 inches), low-defect, single-crystal form, and uniformly doped n-type, p-type and semi-insulating 3C-SiC single crystals.

## Description

### Technical field

The present invention belongs to the technical field of semiconductor materials. Specifically, the present invention relates to a method for preparing 3C-SiC single crystals.

### Background Art

Silicon carbide (SiC) is a wide-bandgap compound semiconductor with excellent properties, with a breakdown field strength and a saturation electron drift rate being respectively 10 times and 2 times those of Si, and with a thermal conductivity being 10 times that of GaAs and 3 times that of Si respectively. These excellent properties impart to SiC unique application advantages in high-temperature, high-voltage, high-frequency and high-temperature devices. These SiC devices have great potential for application in electric vehicles, rail traffic, high-voltage power transmission and transformation, photovoltaics, 5G communications and other fields.

Currently, the main widely used one is 4H-SiC. 4H-SiC is a commonly used crystal form in currently commercial junction barrier Schottky diodes (JBS) and metal oxide semiconductor field effect transistors (MOSFETs) devices.

Different crystal forms can be formed in SiC due to the small difference in the binding energies of SiC crystals formed by Si-C diatomic layers using different stacking manners. There are currently more than 200 crystal forms found in SiC, and the common ones are mainly cubic-, hexagonal-, and rhombohedral-structured SiC. Compared with 4H-SiC, cubic 3C-SiC has a smaller bandgap (2.40 eV), a higher isotropic electron mobility (1000 cm² V⁻¹ S⁻¹), and a lower density of defect states at the SiO₂/3C-SiC interface, and is a potentially ideal substrate for preparing high-frequency, high-temperature, high-power, high-voltage devices and other thin film materials. For example, 3C-SiC can be used as a substrate material for growing GaN epitaxial layers to manufacture SiC-based GaN microwave radio frequency devices.

3C-SiC is unstable. When the temperature is higher than 1900°C, 3C-SiC will be transformed into hexagonal SiC, and this phase transition temperature is lower than the optimal temperature (2000-2300°C) for growing SiC by physical vapor transport (PVT) method. Therefore, it is very difficult to grow large-size, high-quality 3C-SiC single crystal substrates by using the currently most mature PVT method, resulting in almost no high-quality, large-size 3C-SiC single crystal substrates being for sale on the market at present. Chemical vapor deposition (CVD) is usually used to epitaxially grow SiC on Si single crystal substrates. However, due to the lattice mismatch rate of nearly 20% between Si and 3C-SiC and a large thermal expansion coefficient difference, there are high density of defects such as anti-phase grain boundaries, stacking faults, etc., in the grown 3C-SiC single-crystals, and the thickness of the 3C-SiC grown by the CVD method is generally only a few hundred microns. This seriously hinders the research progress of 3C-SiC-based devices. Therefore, it is urgent to develop growth techniques that can grow high-quality, large-size 3C-SiC single crystals.

Compared with the PVT method, the liquid phase method, especially the top seed crystal solution method (TSSG), has the advantages of a low growth temperature (1700-1900°C), can achieve the growth of SiC single crystals in a near thermodynamic equilibrium state, and is expected to grow large-size, high-quality 3C-SiC single crystal substrates. In a literature (Journal of Crystal Growth 318 (2011) 389-393; Journal of Crystal Growth 310 (2008) 1438-1442), 3C-SiC of 18×18 mm² was grown by the TSSG method using Si as a flux. However, by this method, 3C-SiC single crystals can be obtained only on 6H-SiC seed crystals with a deflection angle of 0 degree and there are 6H-SiC single crystals in the grown crystals. Basically, polycrystalline particles are obtained by growth, and no crystal ingots or wafers of single crystals are obtained. Therefore, there is an urgent need for a method that can grow high-quality, large-size 3C-SiC single crystals.

### Contents of the Invention

It is an object of the present invention to provide a method for growing 3C-SiC single crystals, which method is capable of growing high-quality, large-size (such as 2-6 inches) 3C-SiC single crystals, and capable of growing semi-insulating 3C-SiC single crystals, n-type conductive 3C-SiC single crystals or p-type conductive 3C-SiC single crystals.

The above objects of the present invention are achieved by the following technical solutions.

The present invention provides a method for preparing 3C-SiC single crystals, comprising the steps of:
(1) fixing a SiC seed crystal to a graphite seed crystal holder, and then fixing the graphite seed crystal holder to a graphite lifting rod;
(2) placing a flux containing Si and Al in a graphite crucible;
(3) then loading the graphite crucible and the graphite lifting rod into a growth furnace;
(4) vacuumizing the growth furnace, and then introducing a gas to control the gas pressure in the growth furnace and the crystal form of 3C-SiC;
(5) heating the graphite crucible until the flux is completely molten to form a melt and the growth temperature of SiC is reached;
(6) pushing down the graphite lifting rod to make the SiC seed crystals contact with the melt, thereby growing 3C-SiC single crystals;
wherein the flux furthercontains a 3d-transition metal with a melting point lower than the growth temperature of SiC, so as to regulate properties of the flux such as the solubility of C, surface tension, etc..

The inventors of the present application have unexpectedly discovered that when the flux of the present invention contains both Si and Al as well as a 3d-transition metal with a melting point lower than the growth temperature of SiC, and the mixed gas contains nitrogen or oxygen, various types of 3C-SiC single crystals, such as semi-insulating 3C-SiC single crystals, n-type conductive 3C-SiC single crystals or p-type conductive 3C-SiC single crystals, can be prepared.

Without wishing to be bound by theory, in the present invention, the 3d-transition metal can serve to regulate the properties of the flux such as the solubility of C, surface tension, etc..

Preferably, in the method of the present invention, the 3d-transition metal is selected from one or more of Fe, Co, Ni, and Ti.

Preferably, in the method of the present invention, the atomic molar ratio of Si to Al to the 3d-transition metal in the flux is (30-70): (0.01-20): (30-70).

In an embodiment of the present invention, the atomic molar ratio of Si to Al to the 3d-transition metal in the flux is preferably within the above preferred range. Because if the amount of Al is too high, a large amount of Al will be doped into the SiC single crystals, and there are also problems with Al volatilization and SiC crystal cracking; and if the amount of Al is too low, the viscosity of the flux will increase. Similarly, if the amount of the 3d-transition metal is too high, it will lead to the decrease in the amount of Si; and if the amount of the 3d-transition metal is too low, it will lead to too low solubility of C in the flux, which is not conducive to improving the growth rate of SiC single crystals.

Preferably, in the method of the present invention, the flux further contains a rare earth metal with a melting point lower than the growth temperature of SiC. Without wishing to be bound by theory, in the present invention, the rare earth metal can serve to regulate the properties of the flux such as the solubility of C, surface tension, etc..

Preferably, in the method of the present invention, the rare earth metal is selected from one or more of La, Pr and Ce.

Preferably, in the method of the present invention, the atomic molar ratio of Si to Al to the 3d-transition metal to the rare earth metal in the flux is (30-70): (0.01-20): (30-70): (0.1-20).

In an embodiment of the present invention, the molar ratio of Si to Al to the 3d-transition metal to the rare earth metal in the flux is preferably within the above preferred range. Because if the amount of the rare earth metal is too high or too low, it will lead to changes in the solid-liquid interface energy between the flux and the graphite and SiC seed crystals, affecting the growth of SiC single crystals.

Preferably, in the method of the present invention, the flux further contains a Group IIIA and/or IVA metal other than Al that has a melting point lower than the growth temperature of SiC. Without wishing to be bound by theory, in the present invention, the Group IIIA metal other than Al can serve to regulate the properties of the flux such as viscosity, surface tension, thesolubility of C, etc..

Preferably, in the method of the present invention, the Group IIIA and/or IVA metal other than Al is selected from one or more of Ga, In, Ge and Sn.

Preferably, in the method of the present invention, the atomic molar ratio of Si to Al to the 3d-transition metal to the rare earth metal to the Group IIIA metal other than Al in the flux is (30-70): (0.01-20): (30 -70):(0.1-20):(0.1-20).

In an embodiment of the present invention, the molar ratio of Si to Al to the 3d-transition metal to the rare earth metal to the Group IIIA metal other than Al in the flux is preferably within the above preferred range. Because if the amount of the Group IIIA metal other than Al is too high, it will lead to severe volatilization of the flux; and if the amount of the Group IIIA metal other than Al is too low, it will lead to the increase in the viscosity of the flux.

Preferably, in the method of the present invention, vacuumizing the growth furnace in step (4) is to vacuumize the growth furnace to less than 10⁻² Pa.

Preferably, in the method of the present invention, the gas is formed by mixing nitrogen with one or more selected from the group consisting of helium (He), argon (Ar) and hydrogen (H₂), or formed by mixing oxygen with one or more selected from the group consisting of helium (He) and argon (Ar).

Preferably, in the method of the present invention, the volume of nitrogen or oxygen in the gas accounts for 0.1% to 50%.

Preferably, in the method of the present invention, controlling the gas pressure in the growth furnace in step (4) is carried out under the condition that the gas pressure in the growth furnace is controlled to be 0.2-2.0 atm.

Preferably, in the method of the present invention, the SiC seed crystals are SiC wafers of 2-6 inches with a deflection angle of 0°, 4° or 8°.

Preferably, in the method of the present invention, the SiC seed crystals are semi-insulating SiC single crystal substrates, n-type conductive SiC single crystal substrates or p-type conductive SiC single crystal substrates.

Preferably, in the method of the present invention, the inner diameter of the graphite crucible is greater than the diameter of the SiC seed crystals by 5 mm or more; the thickness of the graphite crucible is greater than or equal to 10 mm; the inner wall of the graphite crucible is dense, porous, honeycombed or multi-grooved.

Preferably, in the method of the present invention, growing 3C-SiC single crystals in step (6) is carried out by a process comprising the steps of:
(i) controlling the temperature during the growth of 3C-SiC single crystals so that the temperature at the SiC seed crystals is 1700°C∼1900°C during the growth of single crystals, and that the melt gradually heats up from the surface close to the SiC seed crystals to the bottom of the graphite crucible at a temperature gradient of 3~30°C/cm;
(ii) performing periodically accelerated and decelerated rotation on the SiC seed crystals and the graphite crucible while slowly lifting the SiC seed crystals.

Preferably, in the method of the present invention, the periodically accelerated and decelerated rotation is performed under the conditions that the graphite crucible and the SiC seed crystals are subjected to periodically accelerated and decelerated rotation in opposite directions to each other, the rotation speed is ±0~200 r/min, and the rotational acceleration is ±0~30 r/min².

Preferably, in the method of the present invention, the lifting is performed at a rate of 1 to 3000 µm/h.

In a specific embodiment of the present invention, the flux may be in the form of metal particles or metal blocks. In addition, no compound with a melting point higher than the growth temperature of SiC single crystals is formed from the metals in the flux.

In a specific embodiment of the present invention, the inner diameter of the graphite crucible is greater than the diameter of the seed crystals by 5 mm or more, the thickness of the graphite crucible is not smaller than 10 mm, and the inner wall of the graphite crucible is dense, porous, honeycombed or multi-grooved to increase the contact area between the melt and the graphite crucible, improve the dissolution rate and concentration of C in the melt of the flux, and improve the growth rate and quality of SiC.

In a specific embodiment of the invention, the mixed gas is a mixed gas of nitrogen and argon or nitrogen and helium. The volume percentage of nitrogen is: 0.1%~50%. The mixed gas is introduced until the pressure in the high-temperature growth furnace reaches 0.2-2.0 KPa. During the growth, the mixed gas can be a flowing atmosphere or a non-flowing atmosphere.

In a specific embodiment of the present invention, the graphite crucible and the graphite lifting rod are subjected to periodically accelerated and decelerated rotation in opposite directions to each other, the rotation speed is ±0∼200 r/min, and the rotational acceleration is ±0∼30 r/min². When the graphite lifting rod rotates forward and reverse, the rotation speed of the graphite lifting rod is ±0~200 r/min, and both the forward rotation time and reverse rotation time can be 5~180 min. For example, when the graphite lifting rod rotates forward, the rotation speed is 5~200 r/min, the forward rotation time is 5~180 min, and then the forward rotation speed of the seed crystal rod is slowly decelerated to 0 rpm, and then reversely accelerated to 5~200 r/min, the total time for acceleration and deceleration is 1~60 min, the reverse rotation time of the graphite lifting rod is also 5∼180 min, and it is rotated periodically until the end of growth.

The present invention has the following advantageous effects.

The growth temperature of the present invention is 1700-1900 °C, which is lower than the phase transition temperature of 3C-SiC. The method of the present invention can achieve the growth of high-quality, large-size (such as 2-6 inches), low-defect, single-crystal form, uniformly doped 3C-SiC single crystals, and can also achieve the growth of n-type, p-type and semi-insulating 3C-SiC single crystals. At the same time, the method of the present invention also has the advantages of low growth temperature, easy diameter expansion, low growth cost, and suitability for large-scale industrial production and the like.

### Brief Description of the Drawings

Hereinafter, embodiments of the present invention are described in detail in conjunction with the accompanying drawings, wherein:
FIG. 1 is a photograph of 2-inch 3C-SiC single crystals and 1 mm-thick wafers grown in Example 1; FIG. 1C shows that under strong light, the wafers appear green;
FIG. 2 shows the Hall test results of the 2-inch 3C-SiC single crystals grown in Example 1;
FIG. 3 shows a powder X-ray diffraction pattern tested after the 3C-SiC single crystals grown in Example 1 is ground into powder;
FIG. 4 shows the Raman spectrum of the 3C-SiC single crystals grown in Example 3;
FIG. 5 shows (a) HRTEM and (b) SAED spectra of the 3C-SiC single crystals grown in Example 4;
FIG. 6 shows (a) AFM spectrum and (b) step height distribution diagram of the 3C-SiC single crystals grown in Example 6;
FIG. 7 shows a photograph of 4-inch 3C-SiC single crystals grown by using Example 7;
FIG. 8 shows a defect photograph of 4-inch 3C-SiC single crystals grown by using Example 7; and
FIG. 9 shows a photograph of the SiC single crystals grown in Comparative Example 1.

### Best Mode for Carrying Out the Invention

The present invention is further described in detail below in connection with specific embodiments, wherein the given embodiments are for illustrative purposes only and do not limit the scope of protection of the invention.

### Example 1

A 2-inch semi-insulating SiC single crystal seed crystal substrate with a deflection angle of 0° was fixed to a graphite seed crystal holder with a thickness of 20 mm, and then the graphite seed crystal holder was fixed on a graphite lifting rod. The C-side was used as the growth surface. Si:Ti:Al elementary substance particles with a molar ratio of 60:39.99:0.01 were mixed homogeneously and placed in a graphite crucible and compacted. The graphite crucible had an inner diameter of 55 mm, a height of 100 mm and a wall thickness of 10 mm, and the inner wall of the graphite crucible used was porous and the bottom of the graphite crucible was flat. The graphite crucible and the graphite lifting rod were loaded into a high-temperature growth furnace, the furnace chamber of the high-temperature growth furnace was closed, and the furnace chamber was vacuumized to below 10⁻³ Pa by using a mechanical pump and a molecular pump, and argon and nitrogen with a gas volume ratio of 70:30 were introduced therein until the pressure inside the high-temperature growth furnace reached 0.2 atm. Then the gas valves were closed and the gas filling was stopped. The graphite crucible was heated to control the temperature during the growth of 3C-SiC single crystals so that the temperature at the SiC seed crystals during the growth of single crystals was 1800°C. The graphite lifting rod was pushed down to make it contact with the molten flux and start the growth of 3C-SiC single crystals. During the growth, the temperature gradient of the melt was 10°C/cm. The graphite lifting rod fixed with the SiC seed crystals was rotated in forward and reverse directions at a speed of 100 r/min, with a rotational acceleration of ±30 r/min². The rotation time after starting the rotation of the graphite lifting rod in forward and reverse directions was 5 min, and then it was slowly decelerated to 0 rpm and then accelerated in the opposite direction to 100 r/min, and the total time for the acceleration and deceleration was 10 min, and the cycle was repeated until the end of growth. The graphite crucible was rotated in forward and reverse directions at a speed of 20 r/min, with a rotational acceleration of ±30 r/min². The rotation time after starting the rotation of the graphite crucible in forward and reverse directions was 5 min, and then it was slowly decelerated to 0 rpm and then accelerated in the opposite direction to 20 r/min, and the total time for the acceleration and deceleration was 10 min, and the cycle was repeated until the end of growth. The graphite lifting rod was lifted upward at a speed of 60 µm/h. After growth for 60 h, the graphite lifting rod was lifted upward at a speed of 10 mm/h so as to completely disconnect the grown crystal from the liquid level of the flux melt, and the heating was stopped. Then, the temperature of the grown crystals and the graphite crucible was slowly lowered. After the temperature drops to room temperature, the chamber of the high-temperature growth furnace was opened and the grown crystals were taken out.

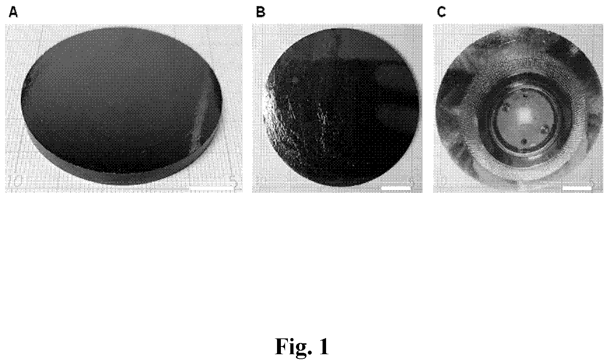

FIG. 1 shows a photograph of 2-inch n-type 3C-SiC single crystals grown in this example.

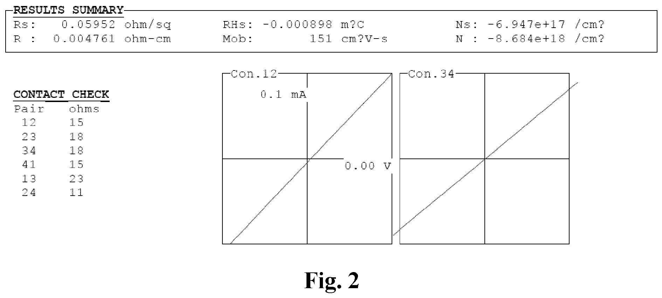

FIG. 2 shows the Hall test results of the n-type 3C-SiC single crystals grown in this example. FIG. 2 illustrates a Hall coefficient of -0.000898 m³/C for the grown n-type 3C-SiC single crystals, demonstrating that the carrier type of the grown SiC single crystals are n-type, with a carrier concentration of 8.684 × 10¹⁸ cm⁻³ and a resistivity of the crystals of 0.004761 Ω• cm.

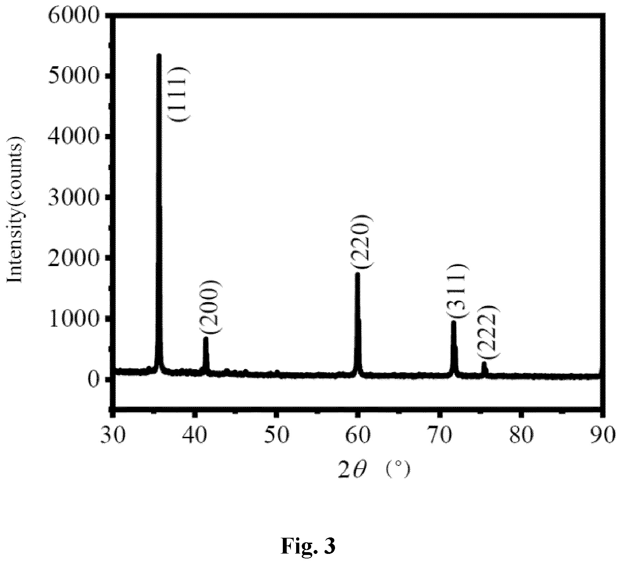

FIG. 3 shows a powder X-ray diffraction pattern of 2-inch n-type 3C-SiC grown in this example tested after being ground into powder, which demonstrates that the materials grown are 3C-SiC single crystals.

### Example 2

A 4-inch n-type 4H-SiC seed crystal single crystal substrate with a deflection angle of 4° was fixed to a graphite seed crystal holder with a thickness of 40 mm, and then the graphite seed crystal holder was fixed on a graphite lifting rod. The C-side was used as the growth surface. Si:Fe:Al elementary substance particles with a molar ratio of 70:10:20 were mixed homogeneously and placed in a graphite crucible and compacted. The graphite crucible had an inner diameter of 150 mm, a height of 150 mm and a wall thickness of 20 mm, and the inner wall of the graphite crucible used was multi-grooved and the bottom of the graphite crucible was a groove being concave in the center and convex on both sides. The graphite crucible and the graphite lifting rod were loaded into a high-temperature growth furnace, the furnace chamber of the high-temperature growth furnace was closed. The furnace chamber was vacuumized to 10⁻⁴ Pa by using a mechanical pump and a molecular pump, and flowing helium and nitrogen with a gas volume ratio of 80:20 were introduced therein, the pressure inside the high-temperature growth furnace was controlled to always be 0.4 atm. The graphite crucible was heated to control the temperature during the growth of 3C-SiC single crystals so that the temperature at the SiC seed crystals during the growth of single crystals was 1700°C. The graphite lifting rod was pushed down to make it contact with the molten flux and start the growth of 3C-SiC single crystals. During the growth, the temperature gradient of the melt was 30°C/cm. The graphite lifting rod fixed with the SiC seed crystals was rotated in forward and reverse directions at a speed of 150 r/min, with a rotational acceleration of ±30 r/min². The rotation time after starting the rotation of the graphite lifting rod in forward and reverse directions was 5 min, and then it was slowly decelerated to 0 rpm and then accelerated in the opposite direction to 150 r/min, and the total time for the acceleration and deceleration was 10 min, and the cycle was repeated until the end of growth. The graphite crucible was rotated in forward and reverse directions at a speed of 0 r/min, with a rotational acceleration of ±0 r/min², until the end of growth. The graphite lifting rod was lifted upward at a speed of 100 µm/h. After growth for 80 h, the graphite lifting rod adhered with the seed crystals was lifted upward at a speed of 10 mm/h so as to completely disconnect the grown crystals from the liquid level of the flux, and the heating was stopped. Then, the temperature of the grown crystals and the graphite crucible was slowly lowered. After the temperature drops to room temperature, the chamber of the high-temperature growth furnace was opened and the grown crystals were taken out. Since the SiC single crystals of this example involved doping of Al and N, the 4-inch semi-insulating 3C-SiC single crystals of the present invention were obtained.

### Example 3

A 6-inch n-type 4H-SiC seed crystal single crystal substrate with a deflection angle of 8° was fixed to a graphite seed crystal holder with a thickness of 10 mm, and then the graphite seed crystal holder was fixed on a graphite lifting rod. The Si-side was used as the growth surface. Si:Co:Y:Al elementary substance particles with a molar ratio of 30:60:5:5 were mixed homogeneously and placed in a graphite crucible and compacted. The graphite crucible had an inner diameter of 200 mm, a height of 150 mm and a wall thickness of 20 mm, and the inner wall of the graphite crucible used was dense plane and the bottom of the graphite crucible was dense plane. The graphite crucible and the graphite lifting rod were loaded into a high-temperature growth furnace, the furnace chamber of the high-temperature growth furnace was closed, and the furnace chamber was vacuumized to below 10⁻⁵ Pa by using a mechanical pump and a molecular pump, and helium and nitrogen with a gas volume ratio of 95:5 were introduced therein until the pressure inside the high-temperature growth furnace reached 0.2 atm. Then the gas valves were closed and the gas filling was stopped. The graphite crucible was heated to control the temperature during the growth of 3C-SiC single crystals so that the temperature at the SiC seed crystals during the growth of single crystals was 1900°C. The graphite lifting rod was pushed down to make it contact with the molten flux and start the growth of 3C-SiC single crystals. During the growth, the temperature gradient of the melt was 10°C/cm. The graphite lifting rod fixed with the SiC seed crystals was rotated in forward and reverse directions at a speed of 20 r/min, with a rotational acceleration of ±5 r/min². The rotation time after starting the rotation of the graphite lifting rod in forward and reverse directions was 5 min, and then it was slowly decelerated to 0 rpm and then accelerated in the opposite direction to 20 r/min, and the total time for the acceleration and deceleration was 1 min, and the cycle was repeated until the end of growth. The graphite crucible was rotated in forward and reverse directions at a speed of 5 r/min, with a rotational acceleration of ±5 r/min². The rotation time after starting the rotation of the graphite crucible in forward and reverse directions was 5 min, and then it was slowly decelerated to 0 rpm and then accelerated in the opposite direction to 5 r/min, and the total time for the acceleration and deceleration was 1 min, and the cycle was repeated until the end of growth. The graphite lifting rod was lifted upward at a speed of 100 µm/h. After growth for 120 h, the graphite lifting rod was lifted upward at a speed of 30 mm/h so as to completely disconnect the grown crystal from the liquid level of the flux melt, and the heating was stopped. Then, the temperature of the grown crystals and the graphite crucible was slowly lowered. After the temperature drops to room temperature, the chamber of the high-temperature growth furnace was opened and the grown crystals were taken out.

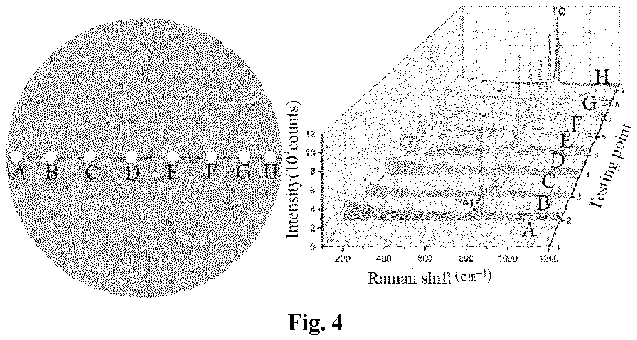

FIG. 4 shows the Raman spectrum of the p-type 3C-SiC single crystals grown in this example. FIG. 4 illustrates that the wafers grown are all 3C-SiC single crystals without any other crystal forms.

### Example 4

A 2-inch n-type 3C-SiC single crystal seed crystal substrate with a deflection angle of 0° was fixed to a graphite seed crystal holder with a thickness of 20 mm, and then the graphite seed crystal holder was fixed on a graphite lifting rod. The Si-side was used as the growth surface. Si:Ni:Ce:Ga:Al elementary substance particles with a molar ratio of 40:30:15:14.9:0.1 were mixed homogeneously and placed in a graphite crucible and compacted. The graphite crucible had an inner diameter of 100 mm, a height of 150 mm and a wall thickness of 20 mm, and the inner wall of the graphite crucible used was honeycombed and the bottom of the graphite crucible was plane. The graphite crucible and the graphite lifting rod were loaded into a high-temperature growth furnace, the furnace chamber of the high-temperature growth furnace was closed, and the furnace chamber was vacuumized to below 10⁻³ Pa by using a mechanical pump and a molecular pump, and helium and nitrogen with a gas volume ratio of 85:15 were introduced therein until the pressure inside the high-temperature growth furnace reached 0.2 atm. Then the gas valves were closed and the gas filling was stopped. The graphite crucible was heated to control the temperature during the growth of 3C-SiC single crystals so that the temperature at the SiC seed crystals during the growth of single crystals was 1900°C. The graphite lifting rod was pushed down to make contact with the molten flux and start the growth of 3C-SiC single crystals. During the growth, the temperature gradient of the melt was 10°C/cm. The graphite lifting rod fixed with the SiC seed crystals was rotated in forward and reverse directions at a speed of 200 r/min, with a rotational acceleration of ±30 r/min². The rotation time after starting the rotation of the graphite lifting rod in forward and reverse directions was 20 min, and then it was slowly decelerated to 0 rpm and then accelerated in the opposite direction to 200 r/min, and the total time for the acceleration and deceleration was 20 min, and the cycle was repeated until the end of growth. The graphite crucible was rotated in forward and reverse directions at a speed of 20 r/min, with a rotational acceleration of ±30 r/min². The rotation time after starting the rotation of the graphite crucible in forward and reverse directions was 5 min, and then it was slowly decelerated to 0 rpm and then accelerated in the reverse direction to 20 r/min, and the total time for the acceleration and deceleration was 10 min, and the cycle was repeated until the end of growth. The graphite lifting rod was lifted upward at a speed of 60 µm/h. After growth for 60 h, the graphite lifting rod was lifted upward at a speed of 10 mm/h so as to completely disconnect the grown crystal from the liquid level of the flux melt, and the heating was stopped. Then, the temperature of the grown crystals and the graphite crucible was slowly lowered. After the temperature drops to room temperature, the chamber of the high-temperature growth furnace was opened and the grown crystals were taken out.

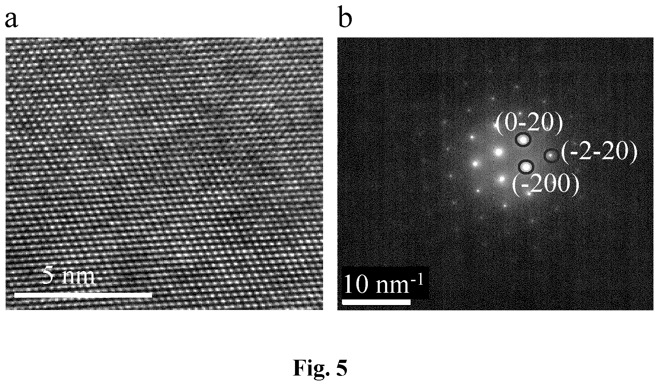

FIG. 5 shows HRTEM and SAED spectra of the n-type 3C-SiC single crystals grown in this example. FIG. 5 further confirms that the grown SiC single crystals are 3C-SiC single crystals.

### Example 5

A 2-inch p-type 3CSiC single crystal wafer with a deflection angle of 0° was fixed to a graphite seed crystal holder with a thickness of 30 mm, and then the graphite seed crystal holder was fixed on a graphite lifting rod. The Si-side was used as the growth surface. Si:Ni:Ce:Ga:Al elementary substance particles with a molar ratio of 40:40:10:2:8 were mixed homogeneously and placed in a graphite crucible and compacted. The graphite crucible had an inner diameter of 100 mm, a height of 150 mm and a wall thickness of 10 mm, and the inner wall of the graphite crucible used was zigzag. The graphite crucible and the graphite lifting rod were loaded into a high-temperature growth furnace, the furnace chamber of the high-temperature growth furnace was closed, and the furnace chamber was vacuumized to below 10⁻³ Pa by using a mechanical pump and a molecular pump, and argon and nitrogen with a gas volume ratio of 95:5 were introduced therein until the pressure inside the high-temperature growth furnace reached 1 atm. The gas valves were closed and the gas filling was stopped. The graphite crucible was heated to control the temperature during the growth of 3C-SiC single crystals so that the temperature at the SiC seed crystals during the growth of single crystals was 1900°C. The graphite lifting rod was pushed down to make it contact with the molten flux and start the growth of 3C-SiC single crystals. During the growth, the temperature gradient of the melt was 10 °C/cm. The graphite lifting rod fixed with the SiC seed crystals was rotated in forward and reverse directions at a speed of 150 r/min, with a rotational acceleration of ±30 r/min². The rotation time after starting the rotation of the graphite lifting rod in forward and reverse directions was 60 min, and then it was slowly decelerated to 0 rpm and then accelerated in the opposite direction to 150 r/min, and the total time for the acceleration and deceleration was 30 min, and the cycle was repeated until the end of growth. The graphite crucible was rotated in forward and reverse directions at a speed of 50 r/min, with a rotational acceleration of ±30 r/min². The rotation time after starting the rotation of the graphite crucible in forward and reverse directions was 60 min, and then it was slowly decelerated to 0 rpm and then accelerated in the opposite direction to 50 r/min, and the total time for the acceleration and deceleration was 30 min, and the cycle was repeated until the end of growth. The graphite lifting rod was lifted upward at a speed of 60 µm/h. After growth for 60 h, the graphite lifting rod was lifted upward at a speed of 10 mm/h so as to completely disconnect the grown crystal from the liquid level of the flux melt, and the heating was stopped. Then, the temperature of the grown crystals and the graphite crucible was slowly lowered. After the temperature drops to room temperature, the chamber of the high-temperature growth furnace was opened and the grown crystals were taken out. The present invention can grow 2-inch p-type 3C-SiC single crystal crystals.

### Example 6

A 6-inch n-SiC single crystal wafer with a deflection angle of 4° was fixed to a graphite seed crystal holder with a thickness of 40 mm, and then the graphite seed crystal holder was fixed on a graphite lifting rod. The Si-side was used as the growth surface. Si:Ni:Ce:Al elementary substance particles with a molar ratio of 40:40: 10: 10 were mixed homogeneously and placed in a graphite crucible and compacted. The graphite crucible had an inner diameter of 200 mm, a height of 200 mm and a wall thickness of 30 mm, and the side wall of the graphite crucible used was processed to be zigzag and the inner bottom surface of the crucible was processed to be porous. The graphite crucible and the graphite lifting rod were loaded into a high-temperature growth furnace, the furnace chamber of the high-temperature growth furnace was closed, and the furnace chamber was vacuumized to below 10⁻³ Pa by using a mechanical pump and a molecular pump, and argon and nitrogen with a gas volume ratio of 70:30 were introduced therein until the pressure inside the high-temperature growth furnace reached 0.8 atm. The gas valves were closed and the gas filling was stopped. The graphite crucible was heated to control the temperature during the growth of 3C-SiC single crystals so that the temperature at the SiC seed crystals during the growth of single crystals was 1900°C. The graphite lifting rod was pushed down to make it contact with the molten flux and start the growth of 3C-SiC single crystals. During the growth, the temperature gradient of the melt was 10°C/cm. The graphite lifting rod fixed with the SiC seed crystals was rotated in forward and reverse directions at a speed of 200 r/min, with a rotational acceleration of ±12 r/min². The rotation time after starting the rotation of the graphite lifting rod in forward and reverse directions was 180 min, and then it was slowly decelerated to 0 rpm and then accelerated in the opposite direction to 200 r/min, and the total time for the acceleration and deceleration was 60 min, and the cycle was repeated until the end of growth. The graphite crucible was rotated in forward and reverse directions at a speed of 100 r/min, with a rotational acceleration of ±12 r/min². The rotation time after starting the rotation of the graphite crucible in forward and reverse directions was 180 min, and then it was slowly decelerated to 0 rpm and then accelerated in the opposite direction to 200 r/min, and the total time for the acceleration and deceleration was 60 min, and the cycle was repeated until the end of growth. The graphite lifting rod was lifted upward at a speed of 60 µm/h. After growth for 80 h, the graphite lifting rod was lifted upward at a speed of 10 mm/h so as to completely disconnect the grown crystal from the liquid level of the flux melt, and the heating was stopped. Then, the temperature of the grown crystals and the graphite crucible was slowly lowered. After the temperature drops to room temperature, the chamber of the high-temperature growth furnace was opened and the grown crystals were taken out.

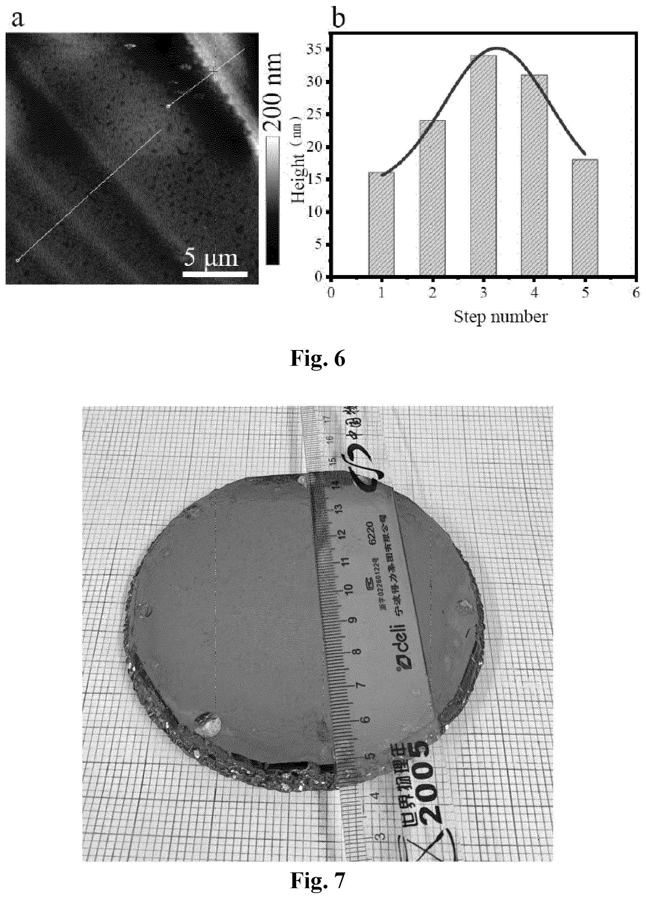

FIG. 6 shows (a) AFM spectrum and (b) step height distribution diagram of the n-type 3C-SiC single crystals grown in this example. FIG. 6 illustrates the growth of 3C-SiC single crystals in a step-flow manner, with the height of the step-flow ranging from 15 to 35 nm.

### Example 7

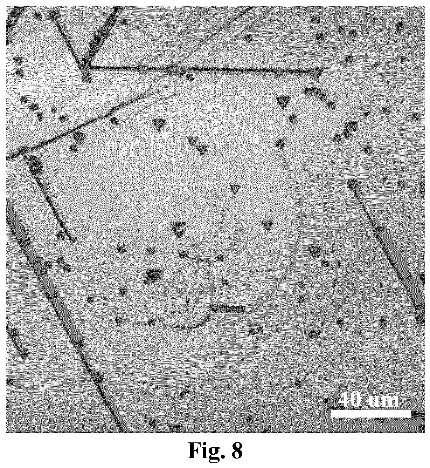

A 4-inch n-type 3C-SiC single crystal wafer with a deflection angle of 0° was fixed to a graphite seed crystal holder with a thickness of 10 mm, and then the graphite seed crystal holder was fixed on a graphite lifting rod. The C-side was used as the growth surface. Si:Ti:Ce:Al elementary substance particles with a molar ratio of 50:40:9.99:0.01 were mixed homogeneously and placed in a graphite crucible and compacted. The graphite crucible had an inner diameter of 150 mm, a height of 200 mm and a wall thickness of 10 mm, and the side wall of the graphite crucible used was processed to be zigzag and the inner bottom surface of the graphite crucible was processed to be porous. The graphite crucible and the graphite lifting rod were loaded into a high-temperature growth furnace, the furnace chamber of the high-temperature growth furnace was closed, and the furnace chamber was vacuumized to below 10⁻³ Pa by using a mechanical pump and a molecular pump, and argon and nitrogen with a gas volume ratio of 80:20 were introduced therein until the pressure inside the high-temperature growth furnace reached 0.8 atm. The gas valves were closed and the gas filling was stopped. The graphite crucible was heated to control the temperature during the growth of 3C-SiC single crystals so that the temperature at the SiC seed crystals during the growth of single crystals was 1900°C. The graphite lifting rod was pushed down to make it contact with the molten flux and start the growth of 3C-SiC single crystals. During the growth, the temperature gradient of the melt was 10°C/cm. The graphite lifting rod fixed with the SiC seed crystals was rotated in forward and reverse directions at a speed of 5 r/min, with a rotational acceleration of ±5 r/min². The rotation time after starting the rotation of the graphite lifting rod in forward and reverse directions was 5 min, and then it was slowly decelerated to 0 rpm and then accelerated in the opposite direction to 5 r/min, and the total time for the acceleration and deceleration was 1 min, and the cycle was repeated until the end of growth. The graphite crucible was rotated in forward and reverse directions at a speed of 5 r/min, with a rotational acceleration of ±5 r/min². The rotation time after starting the rotation of the graphite crucible in forward and reverse directions was 5 min, and then it was slowly decelerated to 0 rpm and then accelerated in the opposite direction to 5 r/min, and the total time for the acceleration and deceleration was 1 min, and the cycle was repeated until the end of growth. The graphite lifting rod was lifted upward at a speed of 150 µm/h. After growth for 120 h, the graphite lifting rod was lifted upward at a speed of 20 mm/h so as to completely disconnect the grown crystal from the liquid level of the flux melt, and the heating was stopped. Then, the temperature of the grown crystals and the graphite crucible was slowly lowered. After the temperature drops to room temperature, the chamber of the high-temperature growth furnace was opened and the grown crystals were taken out to obtain the 4-inch n-type 3C-SiC single crystals as described in this example. FIG. 7 shows a photograph of a 3C-SiC single crystal ingot grown by using this example. FIG. 8 shows a defect photograph of 3C-SiC single crystals grown by using this example. It can be seen that the 3C-SiC grown by the present invention has no anti-phase grain boundary defects and has a stacking fault density of only 150/cm.

### Example 8

A 6-inch semi-insulating 3C-SiC single crystal wafer with a deflection angle of 0° was fixed to a graphite seed crystal holder with a thickness of 30 mm, and then the graphite seed crystal holder was fixed on a graphite lifting rod. The Si-side was used as the growth surface. Si:Ti:Ce:Al elementary substance particles with a molar ratio of 50:40:9.9:0.1 were mixed homogeneously and placed in a graphite crucible and compacted. The graphite crucible had an inner diameter of 200 mm, a height of 300 mm and a wall thickness of 10 mm, and the side wall of the graphite crucible used was processed to be zigzag and the inner bottom surface of the crucible was processed to be porous. The graphite crucible and the graphite lifting rod were loaded into a high-temperature growth furnace, the furnace chamber of the high-temperature growth furnace was closed, and the furnace chamber was vacuumized to below 10⁻³ Pa by using a mechanical pump and a molecular pump, and argon and nitrogen with a gas volume ratio of 99.9:0.1 were introduced therein until the pressure inside the high-temperature growth furnace reached 0.2 atm. The gas valves were closed and the gas filling was stopped. The graphite crucible was heated to control the temperature during the growth of 3C-SiC single crystals so that the temperature at the SiC seed crystals during the growth of single crystals was 1800°C. The graphite lifting rod was pushed down to make contact with the molten flux and start the growth of 3C-SiC single crystals. During the growth, the temperature gradient of the melt was 5°C/cm. The graphite lifting rod fixed with the SiC seed crystals was rotated in forward and reverse directions at a speed of 150 r/min, with a rotational acceleration of ±5 r/min². The rotation time after starting the rotation of the graphite lifting rod in forward and reverse directions was 5 min, and then it was slowly decelerated to 0 rpm and then accelerated in the opposite direction to 5 r/min, and the total time for the acceleration and deceleration was 1 min, and the cycle was repeated until the end of growth. The graphite crucible was rotated in forward and reverse directions at a speed of 30 r/min, with a rotational acceleration of ±5 r/min². The rotation time after starting the rotation of the graphite crucible in forward and reverse directions was 5 min, and then it was slowly decelerated to 0 rpm and then accelerated in the opposite direction to 5 r/min, and the total time for the acceleration and deceleration was 10 min, and the cycle was repeated until the end of growth. The graphite lifting rod was lifted upward at a speed of 150 µm/h. After growth for 84 h, the graphite lifting rod was lifted upward at a speed of 20 mm/h so as to completely disconnect the grown crystal from the liquid level of the flux melt, and the heating was stopped. Then, the temperature of the grown crystals and the graphite crucible was slowly lowered. After the temperature drops to room temperature, the chamber of the high-temperature growth furnace was opened and the grown crystals were taken out to obtain the 6-inch semi-insulating 3C-SiC single crystals described in this example.

### Comparative Example 1

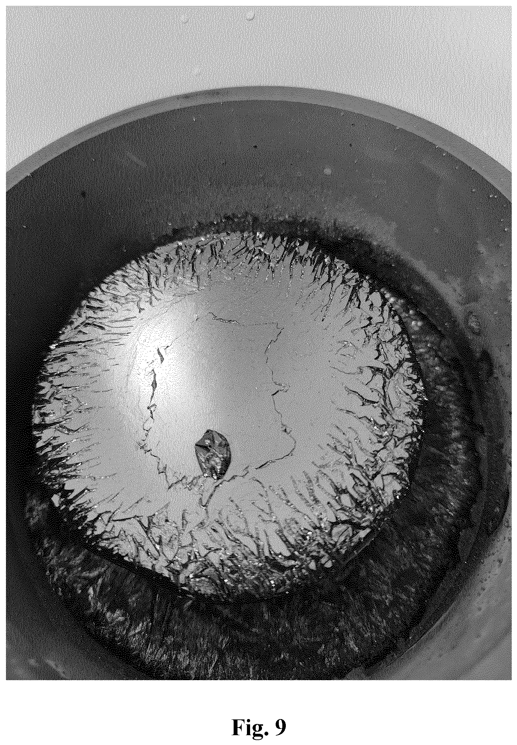

A 4-inch n-SiC single crystal wafer with a deflection angle of 4° was fixed to a graphite seed crystal holder with a thickness of 10 mm, and then the graphite seed crystal holder was fixed on a graphite lifting rod. The C-side was used as the growth surface. Si:Ti:Ce elementary substance particles with a molar ratio of 50:40:10 were mixed homogeneously and placed in a graphite crucible and compacted. The graphite crucible had an inner diameter of 150 mm, a height of 200 mm and a wall thickness of 10 mm, and the side wall of the graphite crucible used was processed to be zigzag and the inner bottom surface of the crucible was processed to be porous. The graphite crucible and the graphite lifting rod were loaded into a high-temperature growth furnace, the furnace chamber of the high-temperature growth furnace was closed, and the furnace chamber was vacuumized to below 10⁻³ Pa by using a mechanical pump and a molecular pump, and argon and nitrogen with a gas volume ratio of 80:20 were introduced therein until the pressure inside the high-temperature growth furnace reached 0.8 atm. The gas valves were closed and the gas filling was stopped. The graphite crucible was heated to control the temperature during the growth of 3C-SiC single crystals so that the temperature at the SiC seed crystals during the growth of single crystals was 1900°C. The graphite lifting rod was pushed down to make contact with the molten flux and start the growth of 3C-SiC single crystals. During the growth, the temperature gradient of the melt was 10°C/cm. The graphite lifting rod fixed with the SiC seed crystals was rotated in forward and reverse directions at a speed of 5 r/min, with a rotational acceleration of ±5 r/min². The rotation time after starting the rotation of the graphite lifting rod in forward and reverse directions was 5 min, and then it was slowly decelerated to 0 rpm and then accelerated in the opposite direction to 5 r/min, and the total time for the acceleration and deceleration was 1 min, and the cycle was repeated until the end of growth. The graphite crucible was rotated in forward and reverse directions at a speed of 5 r/min, with a rotational acceleration of ±5 r/min². The rotation time after starting the rotation of the graphite crucible in forward and reverse directions was 5 min, and then it was slowly decelerated to 0 rpm and then accelerated in the opposite direction to 5 r/min, and the total time for the acceleration and deceleration was 1 min, and the cycle was repeated until the end of growth. The graphite lifting rod was lifted upward at a speed of 150 µm/h. After growth for 120 h, the graphite lifting rod was lifted upward at a speed of 20 mm/h so as to completely disconnect the grown crystal from the liquid level of the flux melt, and the heating was stopped. Then, the temperature of the grown crystals and the graphite crucible was slowly lowered. After the temperature drops to room temperature, the chamber of the high-temperature growth furnace was opened and the grown crystals were taken out. As shown in FIG. 9, the crystal boundaries obtained have many grooves due to the high viscosity of the flux because Al is not added in this comparative example.

### Comparative Example 2

A 4-inch semi-insulating SiC single crystal wafer with a deflection angle of 0° was fixed to a graphite seed crystal holder with a thickness of 10 mm, and then the graphite seed crystal holder was fixed on a graphite lifting rod. The C-side was used as the growth surface. This example used Si and Ce containing no Al as a flux, and the molar ratio of Si to Ce was 90:10. Si and Ce elementary substance particles were mixed homogeneously and placed in a graphite crucible and compacted. The graphite crucible had an inner diameter of 150 mm, a height of 200 mm and a wall thickness of 10 mm, and the side wall of the graphite crucible used was processed to be zigzag and the inner bottom surface of the crucible was processed to be porous. The graphite crucible and the graphite lifting rod were loaded into a high-temperature growth furnace, the furnace chamber of the high-temperature growth furnace was closed, and the furnace chamber was vacuumized to below 10⁻³ Pa by using a mechanical pump and a molecular pump, and argon and nitrogen with a gas volume ratio of 80:20 were introduced therein until the pressure inside the high-temperature growth furnace reached 0.8 atm. The gas valves were closed and the gas filling was stopped. The graphite crucible was heated to control the temperature during the growth of 3C-SiC single crystals so that the temperature at the SiC seed crystals during the growth of single crystals was 1900 °C. The graphite lifting rod was pushed down to make contact with the molten flux and start the growth of 3C-SiC single crystals. During the growth, the temperature gradient of the melt was 10°C/cm. The graphite lifting rod fixed with the SiC seed crystals was rotated in forward and reverse directions at a speed of 5 r/min, with a rotational acceleration of ±5 r/min². The rotation time after starting the rotation of the graphite lifting rod in forward and reverse directions was 5 min, and then it was slowly decelerated to 0 rpm and then accelerated in the opposite direction to 5 r/min, and the total time for the acceleration and deceleration was 1 min, and the cycle was repeated until the end of growth. The graphite crucible was rotated in forward and reverse directions at a speed of 5 r/min, with a rotational acceleration of ±5 r/min². The rotation time after starting the rotation of the graphite crucible in forward and reverse directions was 5 min, and then it was slowly decelerated to 0 rpm and then accelerated in the opposite direction to 5 r/min, and the total time for the acceleration and deceleration was 1 min, and the cycle was repeated until the end of growth. The graphite lifting rod was lifted upward at a speed of 150 µm/h. After growth for 120 h, the graphite lifting rod was lifted upward at a speed of 20 mm/h so as to completely disconnect the grown crystal from the liquid level of the flux melt, and the heating was stopped. Then, the temperature of the grown crystals and the graphite crucible was slowly lowered. After the temperature drops to room temperature, the chamber of the high-temperature growth furnace was opened and the grown crystals were taken out. Almost no grown crystals are seen on SiC seed crystals due to low solubility of C in Si in this example.

It should be noted that the above embodiments are only used to illustrate the technical solutions of the present invention and are not limiting. Although the specific process parameters can be optimized and adjusted, the central concept of the present invention is clear. One skilled in the relevant field should understand that any modifications or equivalent replacements of the technical solutions of the present invention do not depart from the spirit and scope of the technical solutions of the present invention, which should be covered in the scope of the claims of the present invention.

## Claims

1. A method for preparing 3C-SiC single crystals, comprising the steps of:
(1) fixing a SiC seed crystal to a graphite seed crystal holder, and then fixing the graphite seed crystal holder to a graphite lifting rod;
(2) placing a flux containing Si and Al in a graphite crucible;
(3) then loading the graphite crucible and the graphite lifting rod into a growth furnace;
(4) vacuumizing the growth furnace, and then introducing a gas to control the gas pressure in the growth furnace and the crystal form of 3C-SiC;
(5) heating the graphite crucible until the flux is completely molten to form a melt and the growth temperature of SiC is reached;
(6) pushing down the graphite lifting rod to make the SiC seed crystals contact with the melt, thereby growing 3C-SiC single crystals;
wherein the flux further contains a 3d-transition metal with a melting point lower than the growth temperature of SiC.

2. The method according to claim 1, wherein the 3d-transition metal is selected from one or more of Fe, Co, Ni, and Ti.

3. The method according to claim 1, wherein the atomic molar ratio of Si to Al to the 3d-transition metal in the flux is (30-70): (0.01-20): (30-70).

4. The method according to claim 1, wherein the flux further contains a rare earth metal with a melting point lower than the growth temperature of SiC.

5. The method according to claim 4, wherein the rare earth metal is selected from one or more of La, Pr and Ce;
preferably, the atomic molar ratio of Si to Al to the 3d-transition metal to the rare earth metal in the flux is (30-70): (0.01-20): (30-70): (0.1-20).

6. The method according to claim 1, wherein the flux further contains a Group IIIA and/or IVA metal other than Al that has a melting point lower than the growth temperature of SiC.

7. The method according to claim 6, wherein the Group IIIA and/or IVA metal other than Al is selected from one or more of Ga, In, Ge, and Sn;
preferably, the atomic molar ratio of Si to Al to the 3d-transition metal to the rare earth metal to the Group IIIA and/or IVA metal other than Al in the flux is (30-70): (0.01-20): (30 -70):(0.1-20):(0.1-20).

8. The method according to claim 1, wherein vacuumizing the growth furnace in step (4) is to vacuumize the growth furnace to less than 10⁻² Pa;
preferably, the gas is formed by mixing nitrogen with one or more selected from the group consisting of helium, argon, and hydrogen, or formed by mixing oxygen with one or more selected from the group consisting of helium and argon; preferably, the volume of nitrogen or oxygen in the gas accounts for 0.1% to 50%;
preferably, controlling the gas pressure in the growth furnace in step (4) is carried out under the condition that the gas pressure in the growth furnace is controlled to be 0.2-2.0 atm;
preferably, the SiC seed crystals are SiC wafers of 2-6 inches with a deflection angle of 0°, 4° or 8°;
preferably, the SiC seed crystals are semi-insulating SiC single crystal substrates, n-type conductive SiC single crystal substrates or p-type conductive SiC single crystal substrates;
preferably, the inner diameter of the graphite crucible is greater than the diameter of the SiC seed crystals by 5 mm or more; the thickness of the graphite crucible is greater than or equal to 10 mm; the inner wall of the graphite crucible is dense, porous, honeycombed or multi-grooved.

9. The method according to claim 1, wherein growing 3C-SiC single crystals in step (6) is carried out by a process comprising the steps of:
(i) controlling the temperature during the growth of 3C-SiC single crystals so that the temperature at the SiC seed crystals is 1700°C∼1900°C during the growth of single crystals, and that the melt gradually heats up from the surface close to the SiC seed crystals to the bottom of the graphite crucible at a temperature gradient of 3~30°C/cm;
(ii) performing periodically accelerated and decelerated rotation on the SiC seed crystals and the graphite crucible while slowly lifting the SiC seed crystals.

10. The method according to claim 9, wherein the periodically accelerated and decelerated rotation is performed under the conditions that the graphite crucible and the SiC seed crystals are subjected to periodically accelerated and decelerated rotation in opposite directions to each other, the rotation speed is ±0~200 r/min, and the rotational acceleration is ±0~30 r/min²;
preferably, the lifting is performed at a rate of 1 to 3000 µm/h.
